# EUROPEAN PATENT APPLICATION

(11) **EP 4 431 967 A1**
(43) Date of publication of application: **18.09.2024**
(21) Application number: 23161410.8
(22) Date of filing: 13.03.2023
(51) Int. Cl.: G01R 33/56, G01R 33/565, G06N 3/02

(54) **TRAINING OF NEURAL NETWORKS TO GENERATE SYNTHETIC THREE-DIMENSIONAL MAGNETIC RESONANCE IMAGES**

(71) Applicant: Koninklijke Philips N.V., 5656 AG Eindhoven (NL)
(72) Inventor: MEINEKE, Jan Jakob, Eindhoven (NL); DONEVA, Mariya Ivanova, Eindhoven (NL)
(74) Representative: Philips Intellectual Property & Standards

(57) **Abstract**

Disclosed herein is a method of training an image processing neural network (100).
The method comprises repeatedly: receiving (200) a training set of magnetic resonance images (600) each descriptive of a field of view (409) of a subject (418), wherein the training set of magnetic resonance images are acquired according to a synthetic magnetic resonance imaging protocol; receiving (202) at least one two-dimensional training magnetic resonance image (602) acquired from the field of view of the subject; positioning (204) the at least one two-dimensional training magnetic resonance image within a data structure (300) equivalent to the output layer of the image processing neural network; aligning (206) the training set of magnetic resonance images to match the positioning of the at least one two-dimensional training magnetic resonance image; and training (208) the image processing neural network using the aligned training set of magnetic resonance images and the data structure.

## Description

### FIELD OF THE INVENTION

The invention relates to magnetic resonance imaging, in particular to the reconstruction of magnetic resonance images using neural networks.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field. Various protocols and techniques exist to measure different information using magnetic resonance imaging. The particular acquisition protocol and parameters used for an acquisition are referred to herein as a "contrast."

The journal article Pirkl et. al., "Learning residual motion correction for fast and robust 3D multiparametric MRI," Medical Image Analysis 77, 2002, 102387, https://doi.org/10.1016/j.media2022.102387 discloses that voluntary and involuntary patient motion is a major problem for data quality in clinical routine of Magnetic Resonance Imaging (MRI). In quantitative MRI, motion artifacts impair the entire temporal evolution of the magnetization and cause errors in parameter estimation. A strategy based on residual learning for retrospective motion correction in fast 3D whole-brain multiparametric MRI is presented. A 3D multiscale convolutional neural network (CNN) that learns the non-linear relationship between the motion-affected quantitative parameter maps and the residual error to their motion-free reference. For supervised model training, despite limited data availability, a physics-informed simulation to generate self- contained paired datasets from a priori motion-free data is used.

### SUMMARY OF THE INVENTION

The invention provides for a method, a medical system and a computer program in the independent claims. Embodiments are given in the dependent claims.

In synthetic magnetic resonance imaging, several different measurements may be used to acquire magnetic resonance images that have various physical properties encoded in them. The common approach for many synthetic magnetic resonance imaging techniques is a two step process: 1) estimate quantitative parameter maps (T1, T2, proton density) e.g. from MRF (in this case a dictionary matching is used). Other methods for measuring the quantitative maps are also feasible and the T1 and T2 maps are usually estimated using a fitting procedure 2) from the quantitative maps and a given pulse sequence, estimate synthetic MR images that approximate how the images would look like if they are measured with that sequence.

A difficulty with this approach is that both steps contain approximations leading to artifacts in the synthetic images. Using a neural network aims to learn the complex relationship between the input and target thereby reducing the approximative steps and improving image quality.

A difficulty with using neural networks for the reconstruction is that one needs training data, this involves acquiring the magnetic resonance images according to the synthetic magnetic resonance imaging protocol and then one needs the ground truth measurements for a particular magnetic resonance image type or "contrast." These are separate acquisitions, and the subject may have moved between the acquisitions, which would make the training data more or less useless. Another problem is that although the magnetic resonance images for a synthetic magnetic resonance imaging protocol may be acquired for a three-dimensional volume readily it may not be true for the ground truth data. Many types of magnetic resonance images commonly used for acquiring two-dimensional slices take so long to acquire that it presents difficulty when trying to acquire three-dimensional data sets. Often in the attempt to reduce the acquisition time of three-dimensional images, the appearance (the image contrast, not the "contrast" type) of the images is changed making them more difficult to interpret by the radiologists.

Embodiments may overcome this by receiving at least one two-dimensional training magnetic resonance image and then placing it into a data structure which represents a three-dimensional volume. The training set of magnetic resonance images which were acquired according to the synthetic magnetic resonance imaging protocol are then aligned or resampled so that their geometry matches that of the at least one two-dimensional training magnetic resonance image within the data structure. This data is then used for training an image processing neural network.

In one aspect the invention provides for a method of training an image processing neural network. An image processing neural network has an input layer that is configured to receive of set of magnetic resonance images. Each of the set of magnetic resonance images comprises a group of voxels forming a three-dimensional volume. The image processing neural network may be configured to receive this many three-dimensional volumes by increasing the number of inputs in the input layer such that there is an input for each voxel of the three-dimensional volume for each of the set of magnetic resonance images. The three-dimensional volumes input into the neural network may in some examples be stacks of two-dimensional slices.

The image processing neural network further comprises an output layer sized for outputting at least one three-dimensional synthetic magnetic resonance image. The at least one three-dimensional synthetic magnetic resonance image may in some examples be a stack of two-dimensional slices. The image processing neural network would be sized such that for each type of three-dimensional synthetic magnetic resonance image there is a voxel corresponding to this three-dimensional volume. Each of the at least one synthetic magnetic resonance images has a magnetic resonance image type selected from a predetermined group of magnetic resonance image types. Each of the at least one synthetic magnetic resonance image comprises a group of voxels forming the three-dimensional volume.

The method comprises repeatedly receiving a training set of magnetic resonance images each descriptive of a field of view of a subject. The training set of magnetic resonance images are acquired according to a synthetic magnetic resonance imaging protocol. The method further comprises repeatedly receiving at least one two-dimensional training magnetic resonance image that is acquired from the field of view of the subject. The at least one two-dimensional training magnetic resonance image has a ground truth image type selected from the predetermined group of magnetic resonance image types. The method further comprises repeatedly positioning the at least one two-dimensional training magnetic resonance image within a data structure equivalent to the output layer of the image processing neural network. The method further comprises repeatedly aligning the training set of magnetic resonance images to match the positioning of the at least one two-dimensional training magnetic resonance image. The method further comprises repeatedly training the image processing neural network using the aligned training set of magnetic resonance images as input as trial training data and the data structure containing the at least one two-dimensional training magnetic resonance image as ground truth data. The training for example may be performed using a backpropagation or deep learning algorithm.

This embodiment may be beneficial because it may provide a means of training a neural network to take a set of magnetic resonance images that were acquire and then generated using a synthetic magnetic resonance imaging protocol to produce realistic magnetic resonance imaging types. A difficulty in using three-dimensional datasets for training neural networks is the large amount of time required to acquire the training data as well as the ground truth data. Many of the synthetic magnetic resonance imaging protocols are able to acquire data relatively quickly. However, a lot of the more desirable image types for magnetic resonance imaging are typically acquired as two-dimensional slices because it is not really feasible to acquire a full three-dimensional acquisition.

Methods acquire the full input data as a synthetic magnetic resonance image and then use two-dimensional slices acquired on the same field of view to train them. This data is reused or used in this manner by first positioning the two-dimensional slices within the output data structure and then aligning the input data such that it matches. By repeating this process, the image processing neural network can eventually be trained by using these two-dimensional slices of training magnetic resonance images. By providing different magnetic resonance image types, it is also possible to train the image processing neural network to output more than one magnetic resonance imaging type.

In another embodiment aligning the training set of magnetic resonance images comprises an image transformation of the training set of magnetic resonance images. This may take different forms in different examples. If one is taking an image of a brain or the subject's head the structures of the person are relatively stationary relative to each other and a rigid body transformation can be performed. In other examples, there may be deformation of soft tissues. In this case a deformable model may be registered to the ground truth data and the training set of magnetic resonance images. This may enable a flexible and accurate training of the image processing neural network.

In another embodiment the method further comprises constructing a preliminary synthetic magnetic resonance image from the training set of magnetic resonance images and then determining an image registration between the preliminary synthetic magnetic resonance image and the at least one two-dimensional training magnetic resonance image. The alignment of the training set of magnetic resonance images is performed using the image registration. Depending upon the particular synthetic magnetic resonance imaging protocol it may or may not be possible to directly do an image registration to the training set of magnetic resonance images. In the case where it is not possible to do a registration of these images directly, the preliminary synthetic magnetic resonance image is constructed and then this is used to provide a basis for performing the registration. It should be noted that the requirements for making the preliminary synthetic magnetic resonance image may be relatively loose. For example, as long as the preliminary synthetic magnetic resonance image shows basic anatomical structures a registration process may be possible.

In another embodiment the image registration is a rigid body image registration. The alignment of the training set of magnetic resonance images is performed using a rigid transformation.

In another embodiment the image registration is a deformable image registration. The alignment of the training set of magnetic resonance images is performed using a deformable transformation guided by the deformable image registration. This embodiment may be beneficial because it may provide an extremely flexible way of ensuring that even soft tissues of the subject can be modeled accurately.

In another embodiment the training set of magnetic resonance images is a training set of undersampled magnetic resonance images. The set of magnetic resonance images is an undersampled set of magnetic resonance images. This embodiment may be significant because the undersampled images of a synthetic magnetic resonance imaging protocol may be relatively rapid to acquire. This means that these undersampled images may be used to train the neural network to accept undersampled images during deployment of the image processing neural network.

In another embodiment the training is performed using backpropagation limited to portions of the output layer corresponding to portions of the data structure filled by the ground truth data. During the training process the image processing neural network is able to output full image arrays. However, it has been trained by using two-dimensional slices of data which may or may not fill the full three-dimensional volume. To ensure that the data which is empty in the data structure does not affect the training, the backpropagation can be limited to neurons which are connected to the portions of the data structure filled by the ground truth data. That is to say, the backpropagation process can be limited to the portions of the data structure which are filled by the ground truth data.

In another embodiment the predetermined group of magnetic resonance image types comprises a T1 weighted image type.

In another embodiment the predetermined group of magnetic resonance image types comprises a T2 weighted image type.

In another embodiment the predetermined group of magnetic resonance image types comprises a fluid-attenuated inversion recovery (FLAIR) image type.

In another embodiment the predetermined group of magnetic resonance image types comprises a double inversion recovery (DIR) image type.

In another embodiment the predetermined group of magnetic resonance image types comprises a T2-star weighted image type.

In another embodiment the predetermined group of magnetic resonance image types comprises a Dixon water image type.

In another embodiment the predetermined group of magnetic resonance image types comprises a Dixon fat image type.

In another embodiment the predetermined group of magnetic resonance image types comprises a Dixon fat fraction image type.

In another embodiment the predetermined group of magnetic resonance image types comprises a diffusion-weighted image type.

In another embodiment the predetermined group of magnetic resonance image types comprises a functional magnetic resonance image type.

In another embodiment the predetermined group of magnetic resonance image types comprises a proton density magnetic resonance image type.

In another embodiment method further comprises repeatedly acquiring test k-space data from the field of view of the subject by controlling the magnetic resonance imaging system with test pulse sequence commands. The test pulse sequence commands are according to the synthetic magnetic resonance imaging protocol. The method further comprises repeatedly acquiring ground truth k-space data from a portion of the field of view of the subject by controlling the magnetic resonance imaging system with ground truth pulse sequence commands. The ground truth pulse sequence commands according to magnetic resonance imaging protocol that corresponds to the ground truth image type.

The method further comprises repeatedly reconstructing the training set of magnetic resonance images from the test k-space data. The method further comprises reconstructing the at least one two-dimensional training magnetic resonance image from the ground truth k-space data. This embodiment may be beneficial because both the training set of magnetic resonance images and the at least one two-dimensional training magnetic resonance image are both acquired from the same subject.

In another embodiment the method further comprises varying any one of the following during different repetitions: changing the subject, varying the location of the field of view, varying the field of view, varying the ground truth image type, varying the position of the at least one two-dimensional training magnetic resonance image within the data structure, and combinations thereof. This embodiment may be beneficial because it may provide a means of effectively training the image processing neural network.

In another embodiment the image processing neural network is a U-net.

In another embodiment the image processing neural network is a ResNet neural network.

In another embodiment the image processing neural network is a vision transformer neural network.

In another embodiment the image processing neural network is an auto-encoder neural network.

In another embodiment the image processing neural network is a variational auto-encoder neural network.

In another embodiment the image processing neural network is a convolutional neural network.

In another aspect the invention provides for a medical system that comprises a memory storing machine-executable instructions and an image processing neural network that is trained according to an embodiment. The medical system further comprises a computational system. Execution of the machine-executable instructions causes the computational system to receive a set of magnetic resonance images. The set of magnetic resonance images encode multiple tissue properties according to the synthetic magnetic resonance imaging protocol. Each of the set of magnetic resonance images comprises a group of voxels forming a three-dimensional volume. Execution the machine-executable instructions further causes the computational system to receive the at least one three-dimensional synthetic magnetic resonance image in response to inputting the set of magnetic resonance images into the image processing neural network.

In another embodiment the medical system further comprises a magnetic resonance imaging system. The memory further stores acquisition pulse sequence commands configured for controlling the magnetic resonance imaging system to acquire k-space data according to the synthetic magnetic resonance imaging protocol. Execution of the machine-executable instructions further causes the computational system to acquire the k-space data by controlling the magnetic resonance imaging system with the pulse sequence commands. Execution of the machine-executable instructions further causes the computational system to reconstruct the set of magnetic resonance images from the k-space data.

In another embodiment the synthetic magnetic resonance imaging protocol is a three-dimensional magnetic resonance imaging fingerprinting protocol.

In another embodiment the synthetic magnetic resonance imaging protocol is a 3D-QALAS.

In another embodiment the synthetic magnetic resonance imaging protocol is 3D MR-STAT.

In another embodiment the synthetic magnetic resonance imaging protocol is 3D-EPTI.

In another aspect the invention provides for a computer program comprising machine-executable instructions and an image processing neural network. The image processing neural network is trained according to an embodiment. Execution of the machine-executable instructions causes a computational system to receive a set of magnetic resonance images. The set of magnetic resonance images encode multiple tissue properties according to the synthetic magnetic resonance imaging protocol. Execution of the machine-executable instructions further causes the computational system to receive the at least one three-dimensional synthetic magnetic resonance image in response to inputting the set of magnetic resonance images into the image processing neural network.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. K-space data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of an image processing neural network;
Fig. 2 shows a flow chart which illustrates a method of training the image processing neural network;
Fig. 3 illustrates an example of a data structure;
Fig. 4 illustrates an example of a medical system comprising a magnetic resonance imaging system;
Fig. 5 shows a flow chart which illustrates a method of operating the medical system; and
Fig. 6 shows a flow chart which illustrates a method of training the image processing neural network.

### DETAILED DESCRIPTION OF EMBODIMENTS

Like numbered elements in these figures are either equivalent elements or perform the same function. Elements which have been discussed previously will not necessarily be discussed in later figures if the function is equivalent.

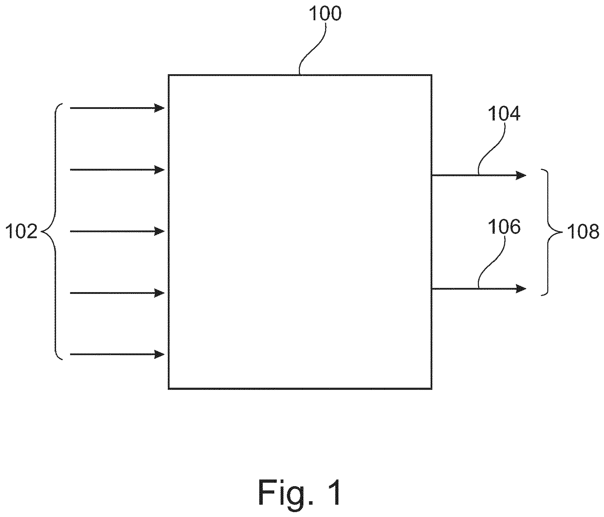

Fig. 1 illustrates the inputs and outputs of an image processing neural network 100. The image processing neural network 100 is shown as having inputs for receiving a set of magnetic resonance images acquired according to a synthetic magnetic resonance imaging protocol 102. The image processing neural network 100 has a number of inputs increased so as to accommodate each element of each of the magnetic resonance images in the set of magnetic resonance images 102.

The image processing neural network 100 in this example is shown as having a first output for a three-dimensional synthetic magnetic resonance image of a first type 104 and a second output of three-dimensional synthetic magnetic resonance image of a second type 106. The image processing neural network 100 had its output layer adjusted so that there is an output for each element of each of the images 104, 106. The number of outputs images 104, 106 is to a certain degree arbitrary and is set during the training process. The two output images 104, 106 form a predetermined group of magnetic resonance image types 108.

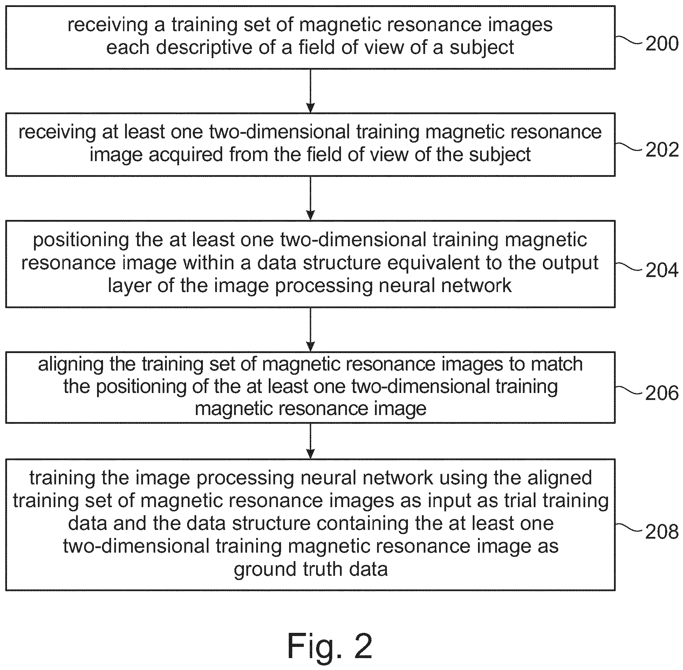

Fig. 2 shows a flowchart which illustrates a method of training the image processing neural network 100. The steps illustrated in Fig. 2 represent a single step in the training of the image processing neural network 100 and may be repeated serially or in parallel many times to train the image processing neural network 100. First, in step 200, a training set of magnetic resonance images is received where each of the set of magnetic resonance images is descriptive of a field of view of a subject. And the training set of magnetic resonance images was acquired according to a synthetic magnetic resonance imaging protocol. This is equivalent to saying that the training set of magnetic resonance images 102 have been acquired according to a chosen or known acquisition protocol.

Next, in step 202, at least one two-dimensional training magnetic resonance image is received. The at least one two-dimensional training magnetic resonance image is from the field of view of the subject. The at least one two-dimensional training magnetic resonance image has a ground truth image type selected from the predetermined group of magnetic resonance image types. In this particular example the ground truth image type would either be the type of the output image 104 or the image 106. If there were more or fewer images that were output by the image processing neural network 100 then these would also be a possibility.

Next, in step 204, the at least one two-dimensional training magnetic resonance image is positioned within a data structure equivalent to the output layer of the image processing neural network. The output of the images 104 and 106 are three-dimensional arrays. The two-dimensional slices or slice are positioned within this three-dimensional array. Next, in step 206, the training set of magnetic resonance images are aligned to match the positioning of the at least one two-dimensional training magnetic resonance image as it is sitting in the data structure. The subject may have moved slightly, either voluntarily or involuntarily, in between the time when the training set of magnetic resonance images and the at least one two-dimensional training magnetic resonance image were acquired. The alignment of the training set of magnetic resonance images to match the positioning of the at least one two-dimensional training magnetic resonance image enables the data to be used for training the neural network. If the anatomies did not match then the image processing neural network 100 would likely not be trained properly. Finally, in step 208, the image processing neural network is trained using the aligned training set of magnetic resonance images as input as trial training data and the data structure containing the at least one two-dimensional training magnetic resonance image as ground truth data 208.

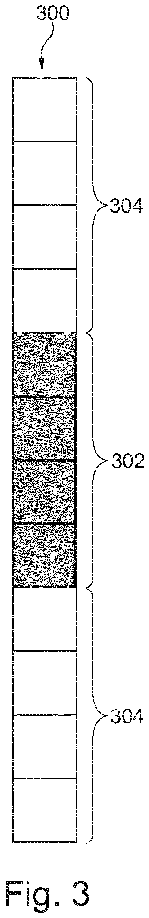

Fig. 3 is used to illustrate one approach towards performing the training of the image processing neural network 100. The blocks illustrated in Fig. 3 represent the data structure 300 into which the at least one two-dimensional training magnetic resonance image is positioned. The shaded blocks labeled 302 represent elements 302 of the data structure which contain the positioned two-dimensional training magnetic resonance images. The blocks 304 represent empty elements. They could either be empty or have a predetermined value inserted into them. The goal is to train the image processing neural network 100 such that it outputs three-dimensional image data in the form of the images 104 and 106. To help to train the data structure 300 backpropagation is performed on the elements 302 which contain the positioned two-dimensional training magnetic resonance images and the empty elements 304 are ignored during the backpropagation process. That is to say backpropagation is performed for the elements 302 whereas the elements 304 backpropagation through the neural network for training is not performed.

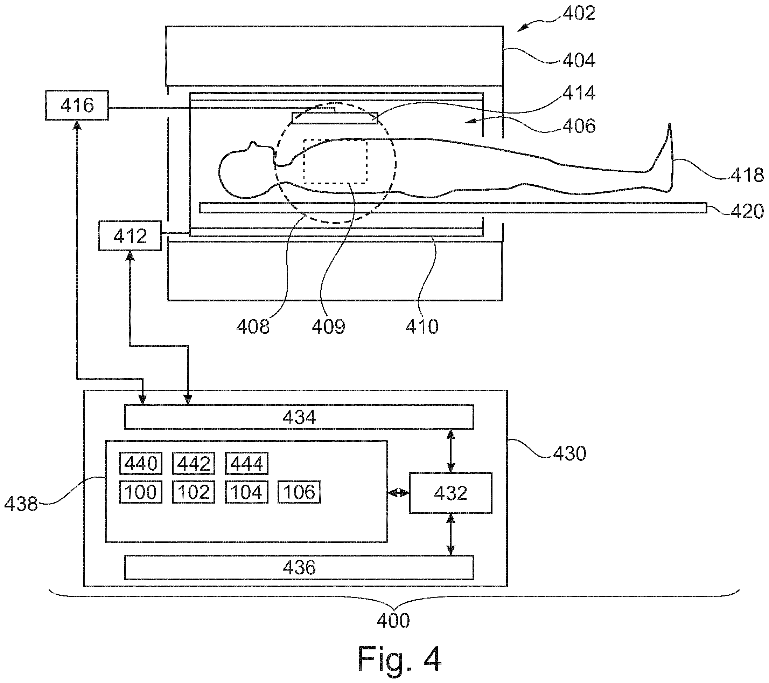

Fig. 4 illustrates an example of a medical system 400 that comprises a magnetic resonance imaging system 402. The magnetic resonance imaging system 402 comprises a magnet 404. The magnet 404 is a superconducting cylindrical type magnet with a bore 406 through it. The use of different types of magnets is also possible; for instance, it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular because the subject is less confined. Inside the cryostat of the cylindrical magnet there is a collection of superconducting coils.

Within the bore 406 of the cylindrical magnet 404 there is an imaging zone 408 where the magnetic field is strong and uniform enough to perform magnetic resonance imaging. A field of view 409 is shown within the imaging zone 408. The magnetic resonance data that is acquired typically acquried for the field of view 409. A subject 418 is shown as being supported by a subject support 420 such that at least a portion of the subject 418 is within the imaging zone 408 and the predetermined region of interest 409.

Within the bore 406 of the magnet there is also a set of magnetic field gradient coils 410 which is used for acquisition of preliminary magnetic resonance data to spatially encode magnetic spins within the imaging zone 408 of the magnet 404. The magnetic field gradient coils 410 connected to a magnetic field gradient coil power supply 412. The magnetic field gradient coils 410 are intended to be representative. Typically, magnetic field gradient coils 410 contain three separate sets of coils for spatially encoding in three orthogonal spatial directions. A magnetic field gradient power supply supplies current to the magnetic field gradient coils. The current supplied to the magnetic field gradient coils 410 is controlled as a function of time and may be ramped or pulsed.

Adjacent to the imaging zone 408 is a radio-frequency coil 414 for manipulating the orientations of magnetic spins within the imaging zone 408 and for receiving radio transmissions from spins also within the imaging zone 408. The radio frequency antenna may contain multiple coil elements. The radio frequency antenna may also be referred to as a channel or antenna. The radio-frequency coil 414 is connected to a radio frequency transceiver 416. The radio-frequency coil 414 and radio frequency transceiver 416 may be replaced by separate transmit and receive coils and a separate transmitter and receiver. It is understood that the radio-frequency coil 414 and the radio frequency transceiver 416 are representative. The radio-frequency coil 414 is intended to also represent a dedicated transmit antenna and a dedicated receive antenna. Likewise, the transceiver 416 may also represent a separate transmitter and receivers. The radio-frequency coil 414 may also have multiple receive/transmit elements and the radio frequency transceiver 416 may have multiple receive/transmit channels. For example, if a parallel imaging technique such as SENSE is performed, the radio-frequency could 414 will have multiple coil elements.

The medical system 400 is further shown as comprising a computer 430. The computer 430 is intended to represent one or more computing or computational devices located at one or more locations. The computer 430 is shown as containing a computational system 432. The computational system 432 is intended to represent one or more computational systems that could for example be one or more processing cores located at one or more locations. Various combinations of computational systems 432 and/or computers 430 could be connected and work together cooperatively using a network. The computational system 432 is shown as being in communication with a hardware interface 434, a user interface 436, and a memory 438.

The hardware interface 434 is an interface which enables the computational system 432 to communicate with and/or control other components of the medical system 400 such as the magnetic resonance imaging system 402. The transceiver 416 and the gradient controller 412 are shown as being connected to the hardware interface 434 of the computer system 430. The user interface 436 is a user interface that enables an operator of the medical system 400 to control and operate the medical system 400. The memory 438 is intended to represent various types of memory which may be in communication with the computational system 432.

The memory 438 is shown as containing machine-executable instructions 440. The machine-executable instructions 440 enable the computational system 432 to control other components of the medical system 400 such as the various components and sub-components of the magnetic resonance imaging system 402. The memory 438 is further shown as containing pulse sequence commands 442. The pulse sequence commands are commands or data which may be converted into commands to control the magnetic resonance imaging system 402 to acquire k-space data according to a particular magnetic resonance imaging protocol. In this case, the pulse sequence commands 442 are configured to acquire the k-space data 444 according to the synthetic magnetic resonance imaging protocol.

The memory 438 is further shown as containing the k-space data 444 that was acquired by controlling the magnetic resonance imaging system 402 with the pulse sequence commands 442. The memory 438 is further shown as containing the image processing neural network 100 that was trained according to the method illustrated in Fig. 2. The memory 438 is further shown as containing a set of magnetic resonance images 102 that were reconstructed from the k-space data 444. The memory 438 is further shown as containing the three-dimensional synthetic magnetic resonance image of the first type 104 and the three-dimensional synthetic magnetic resonance image of the second type 106 that were received in response to inputting the set of magnetic resonance images into the image processing neural network 100.

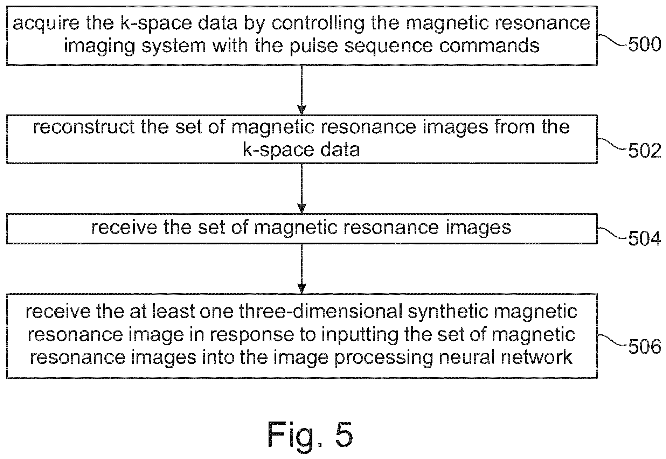

Fig. 5 shows a flowchart which illustrates a method of operating the medical system 400 of Fig. 4. First, in step 500, the k-space data 444 is acquired by controlling the magnetic resonance imaging system 402 with the pulse sequence commands 442. Next, in step 502, the set of magnetic resonance images 102 is reconstructed from the k-space data 444. In step 504, the set of magnetic resonance images 102 are received. Finally, in step 506, the at least one three-dimensional synthetic magnetic resonance image 104, 106 is received in response to inputting the set of magnetic resonance images 102 into the image processing neural network 100.

Examples may provide for an improved method of training of neural networks for "contrast-to-contrast" mapping of MR images by leveraging 3D input data while keeping the target images in 2D. This allows to combine the advantages of 3D data with respect to the possibility of addressing misalignment between images both in-plane and through-plane, with the ability to keep the superior contrast of many 2D images, in particular spin-echo sequences such as T2w, or FLAIR, but also bSSFP.

Synthetically generated MR images have the potential to accelerate clinical MRI by reducing the number of separate acquisitions needed to generate the set of contrasts reaching a confident diagnosis. For example, some techniques offers the creation of synthetic T1w, T2w, FLAIR, DIR, and other standard clinical sequences based on a single scan interleaving multiple echoes and multiple delay times (after magnetization preparation) for T1 and T2 mapping, which is in turn used to compute contrasts based on a signal model. One drawback of this approach is that the appearance of MR images is not solely determined by T1 and T2 (and proton density), but also diffusion, magnetization transfer, flow, etc. It is in general impractical to encode all this information explicitly. However, it has been shown (in ongoing research) that visually convincing synthetic images can be generated using machine-learning approaches. Here, data from a single scan encoding multiple tissue parameters, e.g MR Fingerprinting, is used as input for a neural network trained to approximate acquired contrast-weighted images.

When training neural networks for mapping a given set of input images to a set of output images (target "contrasts") based on acquired in-vivo images, one invariably faces the problem of inter-scan motion. In this way it is close to impossible to achieve perfect correspondence between input and target images, resulting in so-called label noise. This is particularly severe for 2D images, where through-plane motion is impossible to correct via registration.

A direct approach would be to acquire all source and target images in 3D. This may be impractical since it may result in shifting the motion problem leading to artifacts within the scans. More serious, however, is the fact that the contrast of many 3D acquisitions, e.g. FLAIR and T2w, is very much inferior to their 2D counter-parts due to the involved spin-physics and relaxation effects.

Examples may possibly solve the above issues by acquiring only the input images, e.g. from a multi-contrast sequence such as MR Fingerprinting, in 3D. The target contrast images are acquired in 2D with superior contrast. During training of the neural network, and depending on the specific instance of the target image, the corresponding slices of the source images may be determined via registration. This allows training of a contrast-to-contrast neural network with superior contrast, while mitigating voxel-by-voxel registration alignment errors.

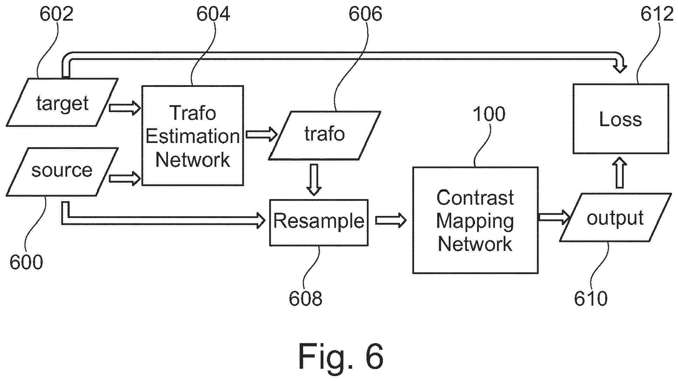

Several options exist for achieving spatial alignment between input and output images on a slice level, in addition to the registration approach above:
- In general, the target images are not mutually aligned, i.e. motion may have occurred between any of the acquired target images. In this case, each target image may correspond to slightly different regions in the input image, and it may be beneficial to use a separate network for each target contrast.
- The estimation of the spatial transformation between input and output images may be included in the training, for example using spatial transformers. Since the actual motion between input and output data is not known, this additional network would be trained using backpropagation using the loss function of the mapping network. However, since the registration network has access to the target image it must be avoided that information from the target image can affect any part of the contrast mapping network (see Fig. 6 below).

Fig. 6 illustrates a method of training the image processing neural network 100. In this example, the training set of magnetic resonance images 600 and the at least one two-dimensional training magnetic resonance image 602 are input into an image registration or transformation module 604. The training set of magnetic resonance images 600 are referred to as the source and the at least one two-dimensional training magnetic resonance image 602 is referred to as the target. The image registration or transformation module 604 could be an algorithmic module that performs a registration, or it could also be a neural network that is trained to perform an image registration and/or calculate a transformation between the two groups of images 600, 602. In any case, the image registration or transformation module 604 outputs an image registration 606 or transformation. This image registration 606 is then used to calculate a resampling 608 of the training set of magnetic resonance images 600. This is then input into the image processing neural network which is referred to as the contrast mapping network in this figure. In response, the image processing neural network 100 outputs the data 610. This is then compared to the at least one two-dimensional training magnetic resonance image 602 to calculate a loss function 612 to perform the training of the image processing neural network 100 ("contrast" mapping network).

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: image processing neural network
- 102: set of magnetic resonance image acquired according to synthetic magnetic resonance imaging protocol
- 104: three-dimensional synthetic magnetic resonance image of a first type
- 106: three-dimensional synthetic magnetic resonance image of a second type
- 108: predetermined group of magnetic resonance image types
- 200: receiving a training set of magnetic resonance images each descriptive of a field of view of a subject
- 202: receiving at least one two-dimensional training magnetic resonance image acquired from the field of view of the subject
- 204: positioning the at least one two-dimensional training magnetic resonance image within a data structure equivalent to the output layer of the image processing neural network
- 206: aligning the training set of magnetic resonance images to match the positioning of the at least one two-dimensional training magnetic resonance image
- 208: training the image processing neural network using the aligned training set of magnetic resonance images as input as trial training data and the data structure containing the at least one two-dimensional training magnetic resonance image as ground truth data
- 300: data structure
- 302: elements containing positioned two-dimensional training magnetic resonance images
- 304: empty elements
- 400: medical system
- 402: magnetic resonance imaging system
- 404: magnet
- 406: bore of magnet
- 408: imaging zone
- 409: field of view
- 410: magnetic field gradient coils
- 412: magnetic field gradient coil power supply
- 414: radio-frequency coil
- 416: transceiver
- 418: subject
- 420: subject support
- 430: computer
- 432: computational system
- 434: hardware interface
- 436: user interface
- 438: memory
- 440: machine executable instructions
- 442: pulse sequence commands
- 444: k-space data
- 500: acquire the k-space data by controlling the magnetic resonance imaging system with the pulse sequence commands
- 502: reconstruct the set of magnetic resonance images from the k-space data
- 504: receive a set of magnetic resonance images, wherein the set of magnetic resonance images encode multiple tissue properties according to the synthetic magnetic resonance imaging protocol
- 506: receive the at least one three-dimensional synthetic magnetic resonance image in response to inputting the set of magnetic resonance images into the image processing neural network
- 600: training set of magnetic resonance image
- 602: at least one two-dimensional training magnetic resonance images
- 604: image registration or transformation module
- 606: image registration
- 608: resampled training set of magnetic resonance images
- 610: output of neural network
- 612: loss function for training image processing neural network

## Claims

1. A method of training an image processing neural network (100), wherein the image processing neural network has an input layer configured to receive a set of magnetic resonance images (102), wherein each of the set of magnetic resonance images comprises a group of voxels forming a three dimensional volume, wherein the image processing neural network further comprises an output layer sized for outputting at least one three-dimensional synthetic magnetic resonance image (104, 106), wherein each of the at least one synthetic magnetic resonance images has a magnetic resonance image type selected from a predetermined group of magnetic resonance image types, wherein each of the at least one synthetic magnetic resonance images comprises the group of voxels forming the three dimensional volume;
wherein the method comprises repeatedly:
- receiving (200) a training set of magnetic resonance images (600) each descriptive of a field of view (409) of a subject (418), wherein the training set of magnetic resonance images are acquired according to a synthetic magnetic resonance imaging protocol;
- receiving (202) at least one two-dimensional training magnetic resonance image (602) acquired from the field of view of the subject, wherein the at least one two-dimensional training magnetic resonance image has a ground truth image type selected from the predetermined group of magnetic resonance image types;
- positioning (204) the at least one two-dimensional training magnetic resonance image within a data structure (300) equivalent to the output layer of the image processing neural network;
- aligning (206) the training set of magnetic resonance images to match the positioning of the at least one two-dimensional training magnetic resonance image; and
- training (208) the image processing neural network using the aligned training set of magnetic resonance images as input as trial training data and the data structure containing the at least one two-dimensional training magnetic resonance image as ground truth data.

2. The method of claim 1, wherein aligning the training set of magnetic resonance images comprises an image transformation of the training set of magnetic resonance images.

3. The method of claim 1 or 2, wherein the method further comprises:
- constructing a preliminary synthetic magnetic resonance image from the training set of magnetic resonance images; and
- determining an image registration between the preliminary synthetic magnetic resonance image and the at least one two-dimensional training magnetic resonance image, wherein the alignment of the training set of magnetic resonance images is performed using the image registration.

4. The method of claim 2 or 3, wherein the image registration is a rigid body image registration, and wherein the alignment of the training set of magnetic resonance images is performed using a rigid transformation.

5. The method of claim 2 or 3, wherein the image registration is a deformable image registration, and wherein the and wherein the alignment of the training set of magnetic resonance images is performed using a deformable transformation guided by the deformable image registration.

6. The method of any one of the preceding claims, wherein the training set of magnetic resonance images is a training set of undersampled magnetic resonance images, and wherein the set of magnetic resonance images is an undersampled set of magnetic resonance images.

7. The method of any one of the preceding claims, wherein the training is performed using backpropagation limited to portions of the output layer corresponding to portions of the data structure filled by the ground truth data

8. The method of any one of the preceding claims, wherein the a predetermined group of magnetic resonance image types comprises any one of the following: a T1 weighted image type, a T2 weighted image type, a fluid attenuated inversion recovery (FLAIR) image type, a double inversion recovery (DIR) image type, a T2-star weighted image type, a Dixon water image type, a Dixon fat image type, a Dixon fat fraction image type, a diffusion weighted image type, a functional magnetic resonance image type, a proton density magnetic resonance image type, and combinations thereof.

9. The method of any one of the preceding claims, wherein the method further comprises repeatedly:
- acquiring test k-space data from the field of view of a subject by controlling a magnetic resonance imaging system with test pulse sequence commands, wherein the test pulse sequence commands are according to the synthetic magnetic resonance imaging protocol;
- acquiring ground truth k-space data from a portion of the field of view of the subject by controlling the magnetic resonance imaging system with ground truth pulse sequence commands, wherein the ground truth sequence commands are according to a magnetic resonance imaging protocol corresponding to the ground truth image type;
- reconstructing the training set of magnetic resonance images from the test k-space data; and
- reconstructing the at least one two-dimensional training magnetic resonance image from the ground truth k-space data.

10. The method of claim 9, wherein the method further comprises varying any one of the following during different repetitions: changing the subject, varying the location of the field of view, varying the field of view, varying the ground truth image type, varying the positioning the at least one two-dimensional training magnetic resonance image within the data structure, and combinations thereof.

11. The method of any one of the preceding claims, wherein the image processing neural network is any one of the following: a U-Net, a ResNet, a Vision Transformer neural network, an auto-encoder neural network, a variational auto-encoder neural network, and a convolutional neural network.

12. A medical system (400) comprising:
- a memory (438) storing machine executable instructions (440) and an image processing neural network (100) trained according to any one of the preceding claims;
- a computational system (432), wherein execution of the machine executable instructions causes the computational system to:
- receive (504) a set of magnetic resonance images 102, wherein the set of magnetic resonance images encode multiple tissue properties according to the synthetic magnetic resonance imaging protocol, wherein each of the set of magnetic resonance images comprises a group of voxels forming a three-dimensional volume; and
- receive (506) the at least one three-dimensional synthetic magnetic resonance image (104, 106) in response to inputting the set of magnetic resonance images into the image processing neural network.

13. The medical system of claim 1, wherein the medical system further comprises a magnetic resonance imaging system (402), wherein the memory further stores acquisition pulse sequence commands (442) configured for controlling the magnetic resonance imaging system to acquire k-space data (444) according to the synthetic magnetic resonance imaging protocol, wherein execution of the machine executable instructions further causes the computational system to:
- acquire (500) the k-space data by controlling the magnetic resonance imaging system with the pulse sequence commands; and
- reconstruct (502) the set of magnetic resonance images from the k-space data.

14. The medical system of claim 12 or 13, wherein the synthetic magnetic resonance imaging protocol is any one of the following: 3D magnetic resonance imaging fingerprinting, 3D-QALAS, MR-STAT, and 3D EPTI.

15. A computer program comprising machine executable instructions (440) and an image processing neural network (100), wherein the image processing neural network is trained using the method according to any one of claims 1 through 11, wherein execution of the machine executable instructions causes a computational system to:
- receive (504) a set of magnetic resonance images (102), wherein the set of magnetic resonance images encode multiple tissue properties according to the synthetic magnetic resonance imaging protocol; and
- receive (506) the at least one three-dimensional synthetic magnetic resonance image (204, 106) in response to inputting the set of magnetic resonance images into the image processing neural network.
